# EUROPÄISCHE PATENTSCHRIFT

(11) **EP 1 488 444 B1**
(45) Veröffentlichungstag und Bekanntmachung des Hinweises auf die Patenterteilung: **02.11.2016**
(21) Anmeldenummer: 03701433.9
(22) Anmeldetag: 19.02.2003
(51) Int. Cl.: H01J 37/34, H01J 37/32

(54) **VAKUUMPLASMAGENERATOR**
VACUUM PLASMA GENERATOR
GENERATEUR DE PLASMA SOUS VIDE

(30) Priorität: 15.03.2002 CH 4582002
(43) Veröffentlichungstag der Anmeldung: 22.12.2004
(73) Patentinhaber: Oerlikon Surface Solutions AG, Pfäffikon, 8808 Pfäffikon (CH)
(72) Erfinder: TUYMER, Gerhard, A-4701 Bad Schallerbach (AT); SCHÜTZE, Andreas, Malibu, CA 90265 (US)
(74) Vertreter: Troesch Scheidegger Werner AG
(86) Internationale Anmeldenummer: PCT/CH2003/000121
(87) Internationale Veröffentlichungsnummer: WO 2003/079397

(56) Entgegenhaltungen:
- WO-A-01/43267
- DE-C- 4 438 463
- DE-U- 29 905 137
- US-A- 5 709 784

## Beschreibung

Die Erfindung bezieht sich auf einen Vakuumplasmagenerator zur Speisung einer Plasmaentladung zur Behandlung von Werkstücken in einer Vakuumkammer gemäss Anspruch 1, sowie ein Verfahren zur Herstellung einer Schicht durch reaktives Abscheiden aus einem Plasma gemäss Anspruch 13.

Elektrische Speisegeräte zum Betreiben von Gasentladungen bzw. Plasmaentladungen für Vakuumprozesse sind auf vielerlei Art und Weise bereits bekannt geworden. Solche elektrischen Speisegeräte werden in der Fachwelt auch als Generatoren bezeichnet. Es ist hierbei wichtig, die Betriebsbedingungen gut kontrollieren zu können, weil die Natur der Plasmaentladung und des damit verbundenen Plasmaprozesses besondere Anforderungen stellt. Neben der zugeführten Spannung, dem Strom und der Entladungsleistung ist insbesondere das Verhalten bei Überschlägen im Plasma, auch als Arc bezeichnet, wie auch mögliche Kurzschlüsse besonders gut zu beherrschen. Solche Lichtbogenentladungen bzw. Arc's treten beim Betreiben von Plasmaentladungen immer wieder auf und erfordern besondere Massnahmen. Insbesondere beim Beschichten mit Hilfe eines Zerstäubungsprozesses, auch als Sputtern bezeichnet, treten solche Überschläge auf und können die Qualität des Produktes negativ beeinflussen oder sogar eine Beschichtung verunmöglichen. Solche Probleme treten dann besonders stark auf, wenn schlecht leitende Schichten oder gar dielektrische Schichten erzeugt werden sollen. Um solche Schichten abzuscheiden, beispielsweise mittels Magnetronsputtern, wird bevorzugt das sogenannte Reaktivzer-stäuben eingesetzt. Hierbei wird beispielsweise das Target einer Magnetronquelle mit einer negativen Gleichspannung versorgt, um ein sogenanntes DC-Plasma zu erzielen, welches beispielsweise mit einem Trägergas wie Argon unterhalten wird und die ionisierten Argonteilchen das Target mit Hilfe eines Stossvorganges zerstäuben. Das Zerstäubungstarget ist hierbei metallisch ausgebildet, also leitfähiges Material, und wird mit zusätzlichem Reaktivgas, beispielsweise Sauerstoff, bei der Zerstäubung zur Reaktion gebracht, wodurch dann eine oxydische Schicht abgeschieden werden kann. Hierbei treten durch die Belegung der umgebenden Oberflächen, aber auch des Targets selbst, mit der oxydischen Schicht die Arc-Probleme auf. Die nichtleitenden beschichteten Oberflächen laden sich auf beim Gleichstromzerstäubungsprozess und es entstehen hierbei die unerwünschten Arc-Entladungen.

Bis anhin hat man sich dahingehend geholfen, dass beispielsweise solche Lichtbogen detektiert werden und dann der Generator kurzzeitig ausgeschaltet wird, um nachher wieder das Plasma hochzufahren. Eine andere bekannte Lösung besteht darin, Hochfrequenzentladungen im MHz-Bereich oder Mittelfrequenzentladungen im kHz-Bereich oder Überlagerungen solcher AC-Spannungen bezüglich einer Gleichstrombasisentladung vorzunehmen. Eine weitere bekannte Möglichkeit besteht darin, bei reaktiven Zerstäubungsprozessen das Plasma mit Hilfe eines DC-gepulsten Generators zu speisen. Der in der Pulsspeisung enthaltene Wechselspannungsanteil, auch AC-Anteil genannt, und/oder die Pulspausen ermöglichen eine periodische Entladung der unerwünschten Aufladungen im Vakuumraum. Da die dielektrischen respektive nichtleitenden Schichten bei diesen Reaktivprozessen relativ dünn sind, beispielsweise im Mikrometerbereich oder weniger, genügen dazu relativ tiefe Frequenzen im Kilohertzbereich. Solche gleichspannungsgepulsten Anordnungen werden als Unipolarpulsanordnungen bezeichnet. Um den Entladungsvorgang an diesen dielektrischen Schichten weiter zu fördern, ist es hilfreich, in der Pausenzeit die Elektrode nicht nur von der Speisung freizuschalten, sondern gegenüber Anode bzw. Masse kurzzuschalten. Hierdurch wird der Entladevorgang gezielt positiv beeinflusst. Eine weitere Beschleunigung des Entladevorgangs kann erreicht werden, wenn in der Pausenzeit, das heisst wenn keine Argonionen mit dem negativen Puls gegen das Target beschleunigt werden, die Spannung sogar kurzzeitig ins Positive geschaltet wird, um ein grösseres Entladungsgefälle für Elektronen zu erzeugen und den Entladevorgang nochmals zu beschleunigen. Hierbei werden also bereits bipolare Pulse eingesetzt, wobei diese aber bevorzugt nicht symmetrisch sind und die negative Puls-Zeitfläche grösser ist als die positive, um hohe Sputterraten zu gewährleisten. Typische Entladungsspannungen bei Magnetronzerstäubungsanordnungen bewegen sich im Bereich von einigen Hundert Volt, typischerweise etwa im Bereich von 400 bis 800 Volt negativ. Je nach Auslegung der Magnetronquelle und der Arbeitsdrücke können die Spannungsbereiche auch grösser oder kleiner sein. Für die beschleunigte Entladung von dielektrischen Aufladungen genügt es hierbei, kurzzeitig in der Pausenzeit auf einige Volt oder einige Zehn Volt positiv zu gehen.

Bekanntgeworden ist weiterhin auch die Möglichkeit, zwei Elektroden als Kathoden zu betreiben, wobei diese wechselseitig einmal kathodisch und das andere Mal anodisch geschaltet werden, das heisst mit einem bipolaren Pulsgenerator betrieben werden. Diese Anordnung wurde auch schon als Twin-Mag bezeichnet. Hierbei ist abwechslungsweise einmal jede Elektrode Kathode und danach Anode. Dies ist eine besonders vorteilhafte Anordnung für reaktive Zerstäubungsprozesse. Gegenüber den bekannten Hochfrequenz-gesteuerten AC-Plasmaanordnungen haben die unipolar bzw. bipolar betriebenen gleichstromgetakteten DC-Anordnungen den Vorteil der hohen Raten. Ausserdem können die komplizierten Reaktivprozesse besser kontrolliert werden. Moderne Generatoren dieser Art werden als steuerbare DC-Generatoren realisiert, wobei insbesondere die Schaltnetzteiltechnik, auch bekannt als Gleichspannungswandler oder im Englischen Sprachgebrauch als Switchmode-Powersupply, bzw. Konverteranordnungen bekannt geworden sind. Schaltnetzteile dieser Art werden, wie in der Elektronik üblich, derart aufgebaut, dass zuerst das Wechselspannungsnetz, beispielsweise das Dreiphasennetz mit 3 x 400 Volt AC 50 Hz, auf übliche Weise gleichgerichtet wird, um eine Gleichspannung zu erzeugen. Die erzeugte Gleichspannung ab dem Netz beträgt dann etwa 550 Volt und wird danach mit Hilfe eines Schaltnetzteils bzw. einem sogenannten DC-DC-Konverter auf die gewünschten Spannungswerte gewandelt. Im wesentlichen wird dazu die Gleichspannung mit Hilfe von Halbleiterschaltern gesteuert zerhackt und über einen Transformator entsprechend hochtransformiert oder tiefgesetzt, wobei die Anordnung über die Halbleiterschalter üblicherweise gesteuert werden kann, beispielsweise in der Pulsbreite, um eine variable einstellbare Ausgangsspannung erzeugen zu können. Selbstverständlich können die Anordnungen auch geregelt werden auf die entsprechend gewünschten Ausgangsspannungen, -ströme oder -leistungen.

Solche Schaltnetzteile bzw. DC-DC-Konverter sind auf vielerlei Arten bekannt geworden und es gibt zwischenzeitlich viele Variationsformen von Ausführungsmöglichkeiten. Für den Betrieb eines Plasmagenerators mit unipolaren Ausgangspulsen zur Plasmaspeisung werden solche DC-DC-Konverter direkt eingesetzt, indem diese primärseitig über die Schalttransistoren gesteuert bzw. getaktet werden, dass ausgangsseitig eine entsprechende pulsierende Gleichspannung entsteht. Bei grösseren Leistungen und für die Erzeugung von bipolaren Ausgangspulsen hat sich auch die Verwendung von Halbleiterbrückenschaltungen, wie mit Transistoren oder Thyristoren, durchgesetzt. Hierbei wird die Brücke in bekannter Weise dazu benutzt, die Polarität der in die Brücke eingespeisten DC-Spannung zu invertieren. Die Last bzw. die Plasmaentladungsstrecke wird hierzu immmer direkt in den Halbleiterbrückenzweig geschaltet. Der Aufwand für die Realisierung dieser bekannten Anordnungen ist beträchtlich. Vorallem im Bezug auf Schutzmassnahmen der Halbleiter bei den hohen Betriebsspannungen und vorallem auch bei hohen Leistungen erfordert dies besondere Schutzmassnahmen für die Halbleiter. Ein weiteres Problem besteht darin, dass bei Überschlägen oder bei Kurzschlüssen schnelle transiente Vorgänge stattfinden, welche zu induzierten Spannungsüberhöhungen führen und zu hohen Stromspitzen, die zusätzlich die empfindlichen Leistungshalbleiter zerstören können. Der Betrieb mit Reaktivprozessen, insbesondere mit schlecht leitenden Materialien oder gar Isolationsschichten bei hohen Leistungen bzw. bei hohen Pulsleistungen und vorallem mit definierten Pulsanstiegszeiten, war bis anhin mit den bekannten Pulsgeneratoren nur bedingt erfolgreich möglich.

In der WO 01/43267 wird eine weitere Stromversorgungsanordnung beschrieben zur Speisung von zwei Magnetron-Sputterquellen mit DC-Pulsen zum reaktiven Zerstäuben von Metallen. Die beiden Targets der Magnetronquellen sind dazu mit der Sekundärwicklung eines Transformators verbunden, wobei dessen Primärwicklung mit einer gepulsten DC-Stromversorgung verbunden und gespiesen wird. Da die Targets mit der Sekundärwicklung direkt DC-gekoppelt sind, neigt der Transformator zur Sättigung. Dies kann vermieden werden, indem im Transformatorkern ein Flusssensor angebracht ist und dieser über eine Steuereinrichtung das Tastverhältnis der DC-Pulse, zur Vermeidung der magnetischen Sättigung des Kernes, entsprechend einstellt. Der Transformator hat die Aufgabe die Magnetronquellen in der Vakuumkammer von der Netzseite isolierend zu trennen und gleichzeitig die Spannung zu transformieren.

In dem Gebrauchsmuster DE 299 05 137 U1 wird eine Schaltungsanordnung zur Speisung einer dielektrisch behinderten Entladung beschrieben. Üblicherweise versteht man darunter, insbesondere Barrieren-Entladungen mit Feststoffisolierungen im Entladungsbereich oder an den Elektroden. Derartige isolierende Dielektrika können aber auch nur zeitweise auftreten und dadurch die Entladung beeinflussen. Derartige Entladungen weisen die besondere Eigenschaft auf, dass sie aufgrund der isolierenden Barriere nur einen Wechselstrom zulassen. Sie weisen erhöhte Anforderungen an die Stabilisierung auf. Ausserdem hat die Entladungsspannung ein hohes Spannungsniveau und müssen fast ausschliesslich mittels einer Transformatoranordnung an die leistungselektronische Schaltungsanordnung angepasst werden. Der energetische Speiseprozess für eine dielektrisch behinderte Entladung erfolgt über den Sekundärkreis eines Transformators dessen Primärseite von einer gesteuerten Wechselrichterschaltung gespiesen wird. Der Transformator dient der Spannungs- und Impedanzanpassung. Die Wechselrichterschaltung wird gespiesen durch eine geregelte Gleichstromquelle mit Spannungsbegrenzerschaltung.

Die Aufgabe der vorliegenden Erfindung liegt darin, die vorerwähnten Nachteile des Standes der Technik zu beseitigen. Insbesondere besteht die Aufgabe darin, einen Vakuumplasmagenerator zu realisieren, der hohe Leistungen im Dauerbetrieb standhält und gleichzeitig in der Lage ist, ein definiertes Pulsverhalten an das Plasma abzugeben, um somit auch die gewünschten Schichteigenschaften realisieren zu können. Es wurde nämlich erkannt, dass die Abscheidung von Schichten mit speziellen geforderten Eigenschaften stark von der Art und Weise der Pulsspeisung des Plasmas und somit des Plasmaentladungsverhaltens abhängig ist.

Die Aufgabe wird erfindungsgemäss durch einen Vakuumplasmagenerator nach Anspruch 1 und durch ein Verfahren nach Anspruch 13 gelöst. Die abhängigen Ansprüche definieren weitere vorteilhafte Ausführungsformen.

Die Aufgabe wird erfindungsgemäss dadurch gelöst, dass ein Vakuumplasmagenerator mit einem Ausgang zur Speisung einer Plasmaentladung zur Behandlung von Werkstücken in einer Vakuumkammer derart aufgebaut wird, dass ein Netzanschluss für den Anschluss an ein Wechselspannungsnetz vorgesehen ist, wobei dieser ein Netzgleichrichter enthält zur Erzeugung einer DC-Spannung und diesem ein DC-DC-Konverter nachgeschaltet ist mit einem Steuereingang zur Einstellung und / oder Regelung der Konverterausgangspannung und an diesen Konverter eine gesteuerte Vollbrückenschaltung mit einem potentialfreien Generatorausgang, welche die Konverterausgangspannung in Pulse von 1 bis 500 kHz umsetzt, wobei in die Brücke ein potentialtrennender Transformator geschaltet ist zur galvanischen Entkopplung des Generatorausganges.

Die Brückenschaltung besteht hierbei aus Schalttransistoren, wobei bevorzugt sogenannte IGBT's eingesetzt werden. Über den vorgeschalteten DC-DC-Konverter kann die Spannung, welche in die Brückenschaltung eingespeist wird, über einen grossen Bereich eingestellt werden. Hierzu hat sich vorallem ein sogenannter getakteter DC-DC-Konverter, also ein Schaltnetzteil, bewährt, welcher vorzugsweise als buck-boost-Konverter realisiert ist. Die eingestellte Ausgangsspannung kann dann sowohl kleiner als auch grösser als die Eingangsspannung sein. Die nachgeschaltete Brückenschaltung wird also nur zur Erzeugung der pulsierenden Ausgangsspannung eingesetzt. Diese kann sowohl unipolar wie auch bevorzugt bipolar sein. Die Plasmaentladungsstrecke wird erfindungsgemäss nicht direkt in die Brücke geschaltet, sondern über einen Trenntransformator, der direkt in die Brücke eingeschaltet ist und als streuarme Ausführung ausgebildet ist. Dieser Transformator hat nicht primär die Aufgabe, die Spannung zu übersetzen, sondern eine Potentialtrennung zu erzeugen und gleichzeitig Rückwirkungen auf die empfindlichen Schalterhalbleiter in der Brücke zu vermeiden, also das Plasma gegenüber der Brückenschaltung zu entkoppeln. Das Übersetzungsverhältnis dieses Transformators soll somit maximal 1:2 betragen, besser aber weniger als 1:1,5. Die Streuinduktivität des Transformators sollte nicht grösser als 50 µH sein, wobei bevorzugt wird diese unter 10 µH zu halten. Dazu sind besondere Wicklungsmassnahmen notwendig. Die Ansteuerung der Brückenschaltung erfolgt mit Vorteil über eine elektronische Steuereinrichtung, wie insbesondere eine Mikroprozessoransteuerung, womit die Einstellung und / oder die Regelung des Pulsverhaltens möglich wird. Es kann also insbesondere ein bipolarer Puls eingestellt werden, es kann die Schaltfrequenz eingestellt werden und das Tastverhältnis der Pulse. Ausserdem kann die Pulsdauer und die Einstellung der Pulsform beeinflusst werden. Zusätzliche Möglichkeiten die Kurvenform zu beeinflussen, bestehen darin, dass der vorgeschaltete Konverter entsprechend abgestimmt moduliert bzw. gesteuert wird.

Wichtig für die reaktive Zerstäubungsanwendung ist das bei der vorliegenden Anordnung zwischen den Pulsen, eine Pulspause eingestellt werden kann und in dieser Pulspause die Elektroden kurzgeschlossen werden über den Transformator bzw. die Brückenschaltung. Dies geschieht durch Kurzschliessen der Primärseite des Transformators mit der Brücke.

Die erfindungsgemässe Anordnung des Generators ermöglicht ausserdem, mehrere Brücken am Konverter parallel zu betreiben und die Ausgänge der Brücken über einen Trafo oder mehrere Transformatoren zusammenzuführen. Mit der vorliegenden erfindungsgemässen Anordnung ist es somit möglich, hohe Pulsleistungen ans Plasma zu führen ohne unzulässige Verzerrungen der Pulsform zu erzeugen und somit das Plasmaverhalten und den Reaktivprozess derart zu beherrschen, dass besonders eindeutige kristalline Ergebnisse in der abgeschiedenen Schicht erzielt werden können. Dazu sind auch sehr hohe Pulsleistungen notwendig, welche durch das erfindungsgemässe Konzept erst realisiert werden kann, ohne Zerstörungen an empfindlichen Halbleiterbauteilen am Generator befürchten zu müssen. Der erfindungsgemässe Generator erlaubt ausserdem eine wirtschaftliche Realisierung der Anordnung.

Die Erfindung wird nun nachfolgend beispielsweise mit schematischen Figuren näher erläutert. Es zeigen:
- Fig. 1: ein Bipolar-Pulsgenerator gemäss Stand der Technik
- Fig. 2: eine prinzipielle Elektrodenanordnung mit Generator
- Fig. 3: ein typischer Spannungs- und Stromverlauf einer bipolaren Pulsanordnung
- Fig. 4: eine erfindungsgemässe Generatoranordnung
- Fig. 5: ein erfindungsgemässer Aufbau der Brückenschaltung mit zwei Brücken
- Fig. 6: Schaltzustände der Anordnung nach Fig. 5
- Fig. 7: eine erfindungsgemässe Anordnung mit zwei Vollbrücken und zwei Transformatoren
- Fig. 8: ein erfindungsgemässer Generator mit vier Vollbrücken und vier Transformatoren
- Fig. 9: ein Transformator mit Wicklungsschema im Querschnitt
- Fig. 10: eine Beschichtungsanlage mit Generator, schematisch und im Querschnitt
- Fig. 11: Kennlinie Targetstrom / Sauerstofffluss für einen erindungsgemässen, reaktiven Zerstäubungsprozesss für die Abscheidung von Al₂O₃
- Fig. 12: Röntgenbeugungsspektrum für eine Al₂O₃-Schicht mit Gamma-Struktur

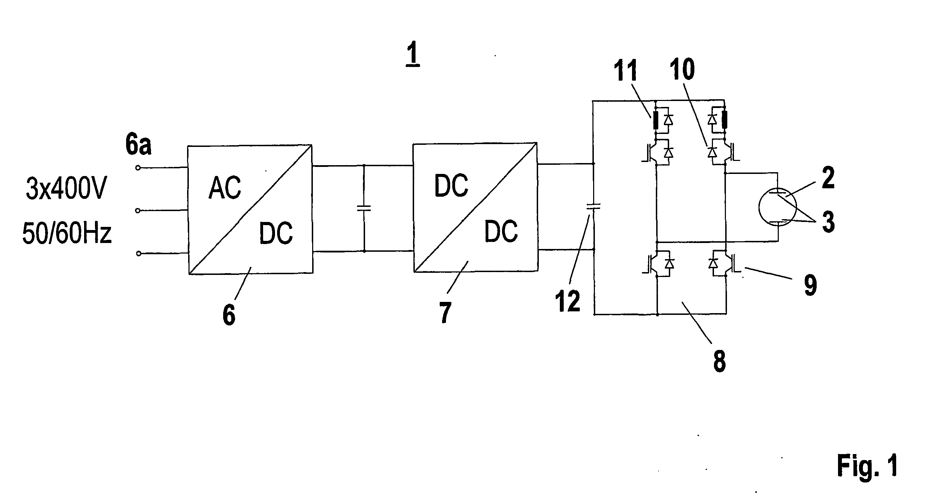

Die Fig. 1 zeigt schematisch den Aufbau eines bekannten Generators 1, welcher wie üblich am Wechselspannungsnetz 3 x 400 Volt AC 50 Hz am Eingang 6a angeschlossen ist. Dieser verfügt über ein eingangsseitiges Gleichspannungsnetzteil 6, 7, wobei sich die in den meisten Anwendungen erforderliche Potentialtrennung vom Versorgungsnetz über einen Transformator im DC-DC-Wandler 7 des Gleichspannungsnetzteils befindet. Zur Erzeugung von gepulsten unipolaren wie auch bipolaren Ausgangsspannungen verfügen die bekannten Generatoren über eine Pulsausgangsstufe 8, die vom Gleichspannungszwischenkreis 12, der hier als Kondensator gezeigt ist, gespeist werden. Im ungünstigen Fall sind diese Pulsausgangsstufe 8 sogar räumlich in einem separaten Gehäuse vom Gleichspannungsnetzteil 6, 7 getrennt. Wesentliche Bestandteile der Ausgangsstufe 8 sind elektrische Schalter wie Transistoren 9 und Freilaufdioden 10. Für zusätzlichen Schutz werden oft auch Induktivitäten 11 in den Schaltkreis eingefügt. Zur Erzeugung von bipolaren Pulsen weist die Ausgangsstufe eine Brückenstruktur auf, wobei die Brücke bei allen bekannten Generatoren direkt den Ausgang bildet, das heisst die Transistoren direkt mit der Last gebildet durch die zwei Elektroden 3 und dem von diesen gezündeten Plasma innerhalb einer Vakuumkammer 2 elektrisch verbunden sind. Eine Schaltungasanordnung dieser Art ist in der EP 0 534 068 B1 beschrieben.

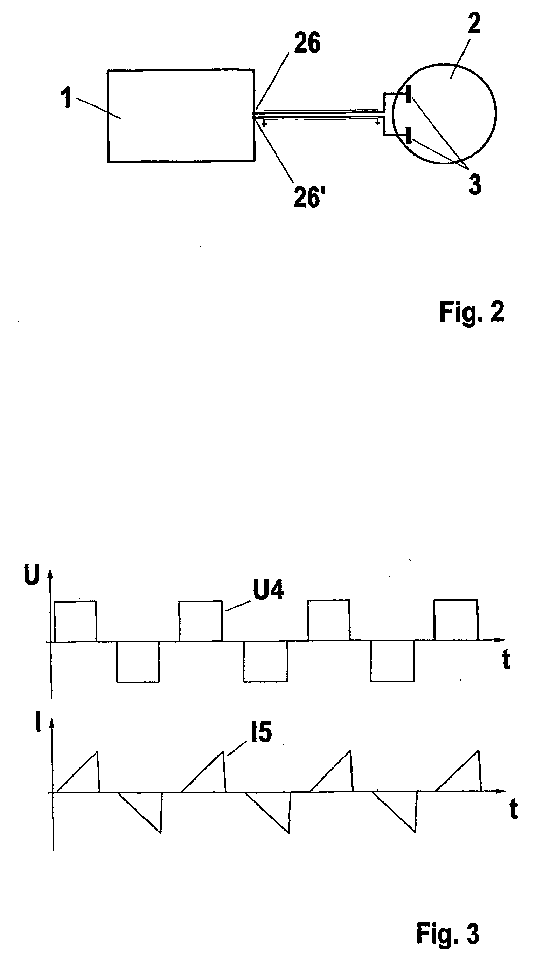

In Fig. 2 ist schematisch der bevorzugte Anwendungsfall des Generators dargestellt. Die beiden Ausgänge 26, 26' des Generators 1 sind mit jeweils einer innerhalb einer Vakuumkammer 2 befindlichen elektrisch isolierten Elektrode 3 verbunden, vorzugsweise Magnetron-Kathoden. In Fig. 3 ist das Spannungsmuster U4 und das Strommuster I5 in Abhängigkeit von der Zeit t für einen Ausgang 26, 26' des Generators 1 bevorzugt dargestellt. Nach jeweils einem positiven rechteckförmigen Spannungspuls erfolgt eine Pause, wonach sich die elektrische Polarität des darauffolgenden Pulses umkehrt. Der über das Plasma sowie die Elektrode 3 und den Generator 1 fliessende Strom I folgt einem etwa dreieckförmigen Verlauf, da zu Beginn eines Pulses vorallem die Anzahl der im Plasma vorhandenen Ladungsträger sowie eine am Ausgang des Generators befindliche Induktivität, wie zum Beispiel die Verdrahtungsinduktivität, Ausgangsfilter etc., einen steileren Anstieg des Stromes verhindert. Während der eine Ausgang dem dargestellten Muster folgt, liegt am anderen Ausgang und an der einen Targetelektrode die jeweils umgekehrte Polarität an. Somit erfolgt ein ständiger Ladungsaustausch zwischen den Elektroden über das Plasma und verhindert elektrische Aufladungen an der Targetoberfläche.

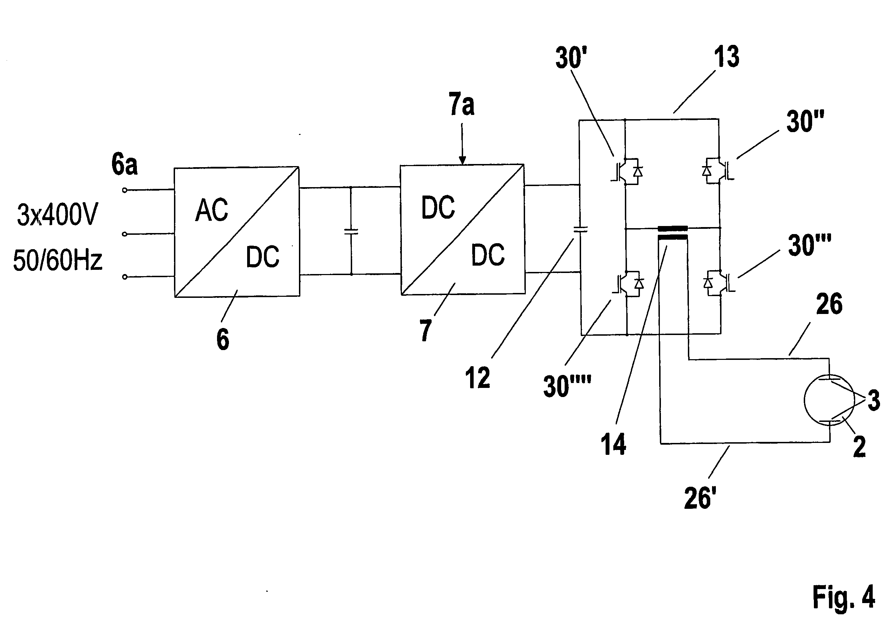

Wesentlich zur Erzielung eines auch über bei industriellem Einsatz langen Zeitraum ohne Schaden funktionierenden Generators auch bei mehreren Hundert kW Spitzenleistungen und Pulsfrequenzen im Bereich von 1 bis 500 kHz oder bevorzugt von 5 bis 100 kHz funktionierenden Generators ist die erfindungsgemässe Anordnung, wie schematisch in Fig. 4 dargestellt. Der Generator weist einen Netzanschluss 6a auf und einen AC-DC-Netzgleichrichter 6, welcher die Netzwechselspannung in eine Gleichspannung umsetzt. Bei den üblichen Dreiphasennetzspannungen von 3 x 400 Volt AC 50 Hz entsteht am Netzgleichrichterausgang eine Gleichspannung von etwa 550 Volt, die mit Kondensatoren zusätzlich geglättet werden kann. Mit dieser Gleichspannung wird nun der DC-DC-Konverter 7 gespiesen, welcher in der Lage ist, eine Gleichspannung zu erzielen, die tiefer oder höher ist als die eingespiesene Spannung. Dieser Konverter 7 besteht aus einem Schaltnetzteil, welches vorzugsweise als buck-boost-Konverter ausgebildet ist, um die erforderlichen Tief- und Hochsetzstellereigenschaften zu erzielen. Solche buck-boost-Konverter sind beispielsweise beschrieben in "Power Electronics von Mohan, Undeland, Robbins; Verlag John Wiley & Sons, Inc; Ausgabe 2nd ed. 1995". Diese Technologie ermöglicht ausserdem die Verwendung von mehreren parallel betriebenen buck-boost-Konvertern, welche jeweils vorzugsweise um eine bestimmte Phase gegenüber der Schaltimpulse versetzt ist, um die Rippelstrombelastung in dem nachgeschalteten Zwischenkreiskondensator zu reduzieren und um mit geringeren Kapazitätswerten auszukommen. Ausserdem wird die Belastung der einzelnen Konverter aufgeteilt. Geeignet hat sich in der Praxis eine Anordnung mit vier derartigen Konvertern, welche jeweils um eine Viertel Periode versetzt geschaltet sind. Bei dem vorgeschlagenen erfindungsgemässen Aufbau des Konverters 7 können mit Vorteil die weit verbreiteten und bewährten IGBT-Module als Schalter eingesetzt werden, welche Spannungen bis 1200 Volt verarbeiten können. Bei dieser Schaltungsanordnung ist es ohne weiteres möglich, bereits im Bereich des DC-DC-Konverters 7 die notwendigen Leistungsspitzen bereitstellen zu können, die grösser 50 kW sind oder gar einige Hundert kW betragen können.

Am Ausgang des DC-DC-Konverters 7 ist mit Vorteil ein Zwischenkreiskondensator 12 als Glättungskondensator nachgeschaltet. Der Konverter 7 stellt somit die am Ausgang erforderliche Betriebsspannung zur Verfügung und ist mit einem entsprechenden Steuereingang 7a versehen, durch welchen die gewünschte Spannung eingestellt oder geregelt werden kann. Selbstverständlich kann auch auf einen am Ausgang gemessenen Strom oder Leistung geregelt werden mit der entsprechenden Regelelektronik. Zur Aufarbeitung der entsprechenden Steuerspannungen haben sich Mikroprozessorschaltungen bewährt. Nach dem Zwischenkreiskondensator 12 des Konverter 7 ist eine Vollbrückenschaltung 13 bestehend aus vier Halbleiterschaltern wie Schalttransistoren 30'bis 30'''' nachgeschaltet. Auch diese Schalttransistoren sind vorzugsweie IGBT-Transistoren. Da eine vollkommen symmetrische Ausgangsstruktur der Bauelemente des Generators anwendungsbedingt vorteilhaft ist, um eine symmetrische Leistungsansteuerung der Elektroden zu gewährleisten und um wegen der Schwingneigung von Elektrodenspannung und Plasmastrom die Störungen auf der Ansteuerseite der Transistoren zu minimieren, wurde, anders als bei bekannten Generatoren, der für die Potentialtrennung vom Netz erforderliche Transformator 14 als wesentliches Funktionselement in der vorliegenden Brückenanordnung 13 direkt am Ausgang des Generators 1 angeordnet. Dies ist dadurch möglich, da in der vorliegenden Anwendung die Ausgangsspannung zwischen den Elektroden 3, im bevorzugten Betriebsfall, gleich-anteilsfrei ist, also symmetrisch um den Spannungsnullpunkt schwingt. Die Schalttransistoren 30 der Brückenschaltung 13 werden ebenfalls mit Hilfe einer Steuerelektronik, vorzugsweise mit einer Mikroprozessorelektronik, gezielt angesteuert.

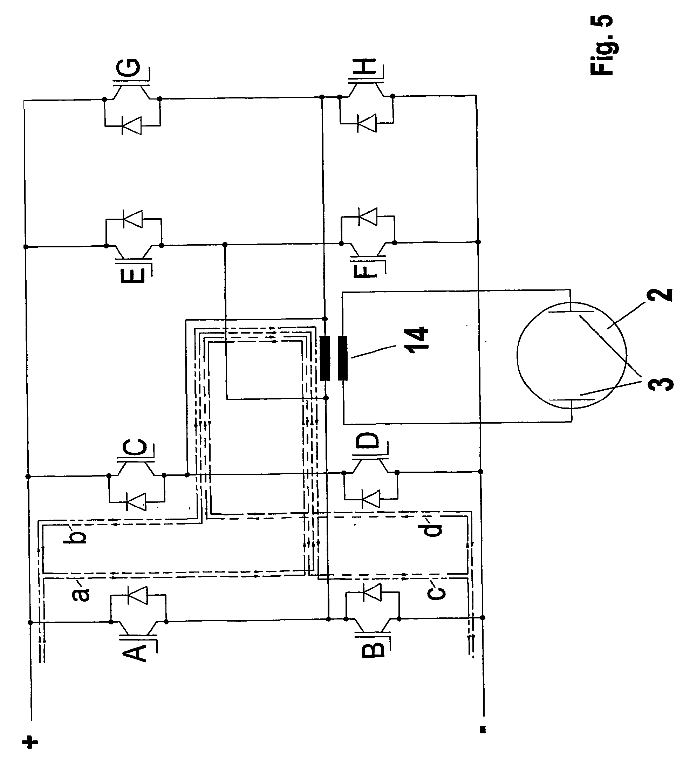

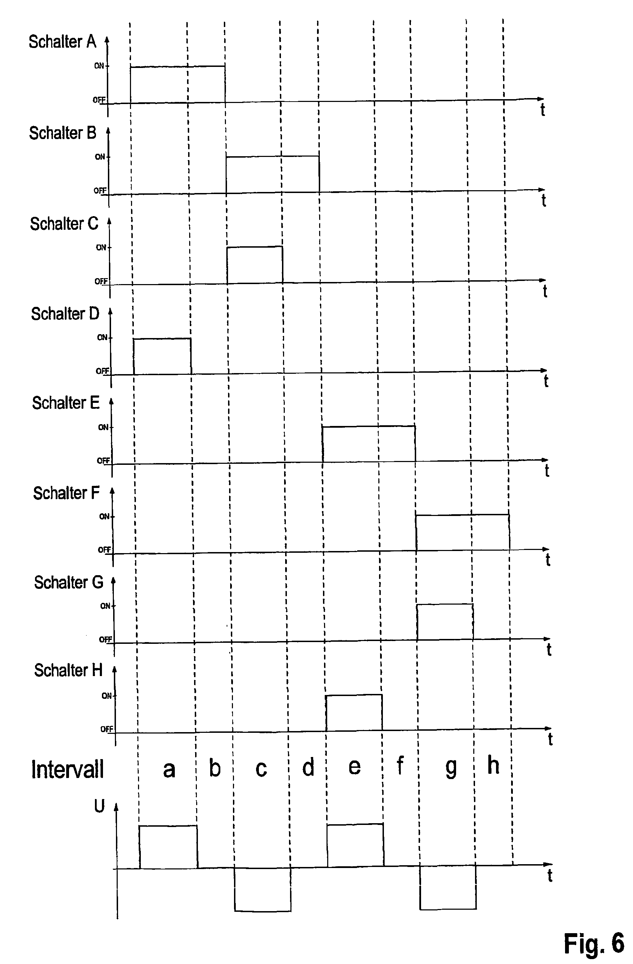

Eine weitere bevorzugte Ausführung der erfindungsgemässen Anordnung ist eine Schaltungsstruktur der Vollbrücke 13 entsprechend der Fig. 5, die neben einer hohen Ausgangsleistung auch eine hohe Ausgangsfrequenz ermöglicht. Hier werden im wesentlichen zwei Vollbrücken parallel betrieben an einem einzigen DC-DC-Konverterausgang 7, wobei hier die beiden Brückenschaltungen vorzugsweise zeitversetzt betrieben werden. Beim Aufbau einer Schaltung in der nur die mindeste erforderliche Anzahl an Transistoren Verwendung findet, um ein bipolares Spannungsmuster am Ausgang 26, 26' des Generators 1 aufzubauen, wird die Ausgangsfrequenz durch die maximale Schaltfrequenz jedes einzelnen Transistors bestimmt. Die maximale Schaltfrequenz der Transistoren, also die minimale Zeit zwischen zwei Einschaltvorgängen, wird massgeblich durch die Zeit beansprucht, die abgewartet werden muss bis sich zum einen die thermische Belastung durch den Ein- und Ausschaltvorgang, sowie während der Einschaltzeit des Transistors, abgebaut hat und zum andern sich die Ladungsträger in den Schaltkreisen des Transistors wieder abgebaut haben. Als Ausweg aus diesem Problem wurde wegen der anwendungsbedingt hohen erforderlichen Ausgangsfrequenz und den hohen Schaltströmen eine höhere Schaltfrequenz am Ausgang erzielt, indem nicht nur eine Vollbrücke eingesetzt wird, sondern vorteilhafterweise zwei oder mehrere Vollbrücken, die prinzipiell parallelgeschaltet betrieben werden, aber zeitlich versetzt geschaltet werden, wodurch eine höhere Ausgangsschaltfrequenz am Generator erzielt werden kann, als die einzelnen Transistoren erbringen müssen. Durch eine Ansteuerung der Transistoren A bis H mit den zugehörigen Strompfaden a bis h gemäss Fig. 5 und gemäss dem Muster nach Fig. 6 gelingt eine Verdoppelung bzw. Vervielfachung der resultierenden Ausgangsfrequenz zwischen den Elektroden 3 am Ausgang 26, 26' des Generators gegenüber der Schaltfrequenz der einzelnen Transistoren A bis H.

Durch diese Massnahme kann eine anwendungsbedingte resultierende Ausgangsfrequenz erreicht werden, die höher als die maximal erzielbare Schaltfrequenz der eingesetzten Transistoren ist. Fig. 5 und 6 zeigen die Schaltzustände der Transistoren A bis H und die resultierenden Stromverläufe a bis h für einen Schaltzyklus aller Transistoren und den resultierenden bipolaren Ausgangspuls mit Pausen. Dies entspricht zwei Perioden der Ausgangsspannung des Generators. Im Intervall a schalten die Transistoren A und D ein und der Strom fliesst vom positiven Pol des Zwischenkreises über den Transistor A über die Primärseite des Transformators über den Transistor D in den negativen Pol der Zwischenkreiskondensatoren 12. Währende dieser Phase liegt beispielsweise eine positive Polarität an einem der beiden Ausgänge 26, 26' des Generators. Während des Intervalls b ist nun der Transistor D ausgeschaltet und der Stromfluss baut sich ab und fliesst über die Freilaufdiode des Transistors C und den weiterhin eingeschalteten Transistor A. Desweiteren schaltet auch Transistor A aus und die beiden diagonal angeordneten Transistoren C und B schalten ein, woraufhin der Strom nun entgegengesetzt zur vorherbeschriebenen Transistorstellung durch die Primärseite des Transformators 14 fliesst und sich an den beiden Ausgängen des Generators 26, 26' nun die entgegengesetzte Polarität aufbaut. Der vollständige Verlauf der Intervalle a bis h ergibt, so wie in Fig. 6 dargestellt, zwei Perioden der Potentialwechsel an den Ausgängen des Generators. Für eine bevorzugte Ausführungsform des Generators wird für die Erzeugung eines stabilen und ruhigen Plasmas bzw. für ein Plasma, bei welchem das Arcing weitestgehend vermieden wird, die beiden Elektroden 3, welche am Ausgang 26, 26' angeschlossen sind, in der Pulspause gegeneinander kurzgeschlossen. In der hier dargestellten Ausführungsform bleiben in der Pulspause gezielt Schalter eingeschaltet und es wird so ein Freilaufkreis geschaffen, über den sich der primärseitige Strom abbaut. Die Elektroden sind somit über die Sekundärseite des Transformators 14 kurzgeschlossen.

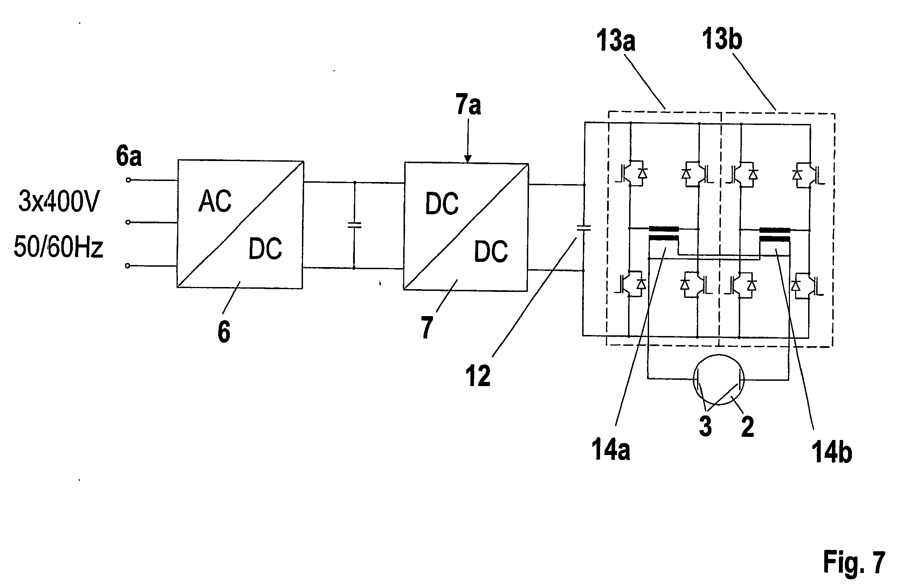

Bei der vorerwähnten Schaltung wurde ein einzelner Transformator 14 verwendet und die mehreren Brückenschaltungen primärseitig auf den einen Transformator 14 geschaltet. Um eine weitere Leistungsaufteilung und Symmetrierung auf die beiden Transistorvollbrücken 13a, 13b zu ermöglichen oder auf mehrere Vollbrücken, wurden wie in Fig. 7 dargestellt, jeder Vollbrücke 13a, 13b ein eigener Transformator 14 zugeteilt. Die einzelnen Transformatoren 14a, 14b sind sekundärseitig parallel geschaltet und auf den Ausgang 26, 26' des Generators geführt, wo beide Elektroden 3 angeschlossen werden können.

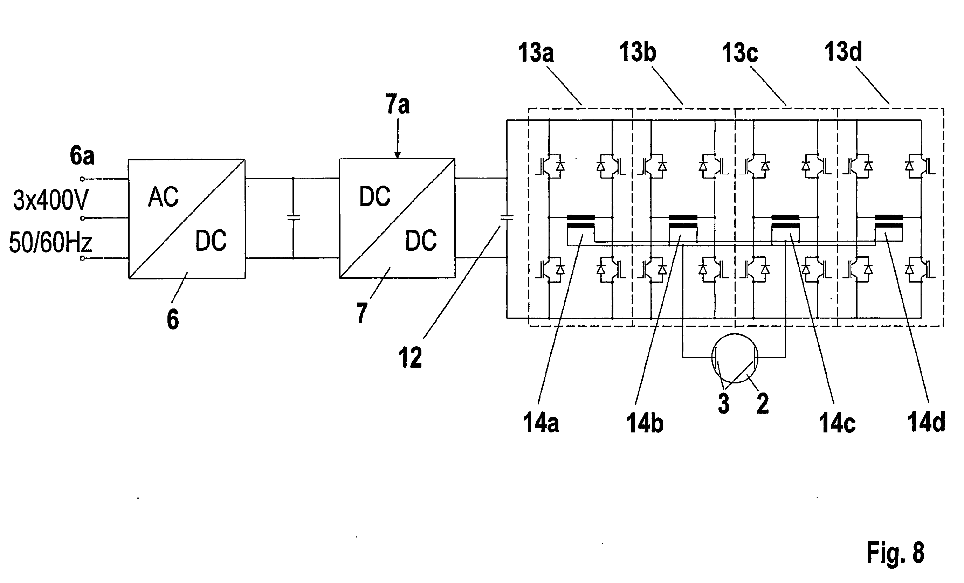

Durch Erzielung der erwünschten sehr hohen Ausgangsleistungen über 50 kW ist eine weitere Parallelschaltung von Brükken gegenüber dem Beispiel aus Fig. 7 vorteilhaft, da die Strombelastung in den einzelnen Transistoren damit weiter reduziert werden kann. Ein solcher Aufbau ist beispielsweise in Fig. 8 dargestellt, wo vier solche Brückenschaltungen 13a bis 13d verwendet werden. Zur guten Entkopplung wurde bei diesem Beispiel für jede Brücke je ein Transformator 14a bis 14d vorgesehen und sekundärseitig am Ausgang zusammengeschaltet. Wie bereits erwähnt ist auch die Verwendung nur eines Transformators 14 möglich.

In einem Frequenzbereich von 1 bis 50 kHz ist die Anwendung von IGBT's als Schalter von Vorteil, da diese den derzeitigen Stand der Technik bei Parallelschaltung zweier Brücken einen genügend hohen Strom schalten können. Zur Erreichung eines Frequenzbereiches von 50 bis 500 kHz sollten statt der IGBT's sogenannte MOSFET's zum Einsatz kommen, da diese schneller schalten können. Nachteil bei der Verwendung von MOSFET's ist deren Möglichkeit zur Schaltung geringerer Ströme, so dass mehrere MOSFET's parallel geschaltet werden müssen. Eine Erhöhung der Schaltfrequenz bei unveränderter Impulseinschaltdauer, also eine Reduzierung der Pausenzeit, kann auch durch das Hinzufügen einer zusätzlichen Brücke und alternierendes Ansteuern, wie dies bereits in Fig. 5 diskutiert wurde, erzielt werden.

Der Transformator 14 spielt für die Funktion der erfindungsgemässen Anordnung eine wesentliche Rolle. Um das erforderliche Verhalten erzielen zu können, ist es zwingend notwendig, dass die Streuinduktivität des Transformators 14 möglichst gering gehalten wird. Der Transformator 14 sollte derart ausgelegt werden, dass diese Streuinduktivität auf jeden Fall weniger als 50 µH beträgt oder besser gar weniger als 10 µH. Hierzu ist es erforderlich, dass die Übersetzungsverhältnisse klein sind, was das vorliegende Konzept des Generators ermöglicht. Das Übersetzungsverhältnis sollte möglichst nicht über 1:2 betragen oder noch besser weniger als 1:1,5 sein. Das Kernmaterial 27 bei den vorliegenden Frequenzen ist aus Ferrit gefertigt und wird aus mehreren Kernen 27 zusammengesetzt, um auf das notwendige Kernvolumen zu kommen. Für ein typisches Ausführungsbeispiel einer erfindungsgemässen Generatoranordnung mit einer Betriebsfrequenz von 25 bis 50 kHz und einer übertragenen Leistung von 50 kW wurde folgende Trafoausführung realisiert:
Der Kern 27 besteht aus Ferritmaterial, wobei neun Stück hintereinander als E-Kern-paare 80/38/20 angeordnet worden sind.

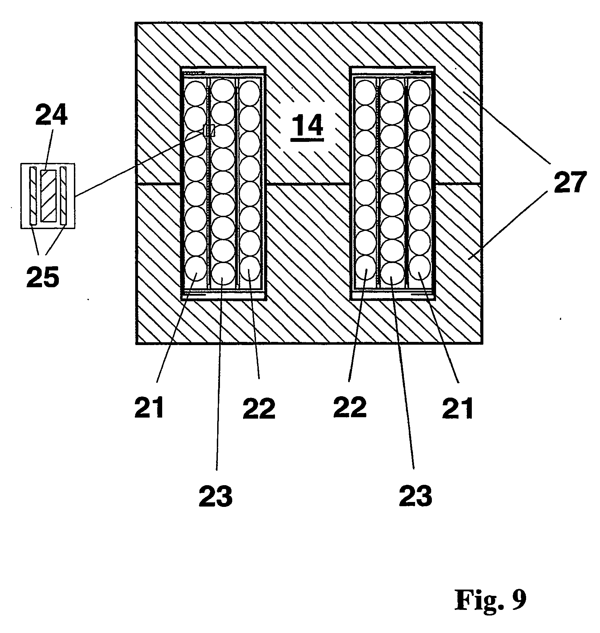

Das Übersetzungsverhältnis der Wicklung betrug 8:9 Windungen. Die Primärspannung war 0 bis 725 Volt (Amplitude) und der Primärstrom 0 bis 170 Ampere (Amplitude) einstellbar am Konverter 7, wobei der Gleichrichtmittelwert des Stromes 0 bis 36 Ampere betrug. Der Kupferwiderstand primärseitig betrug ca. 7 mOhm bei 100 °C und sekundärseitig ca. 15 mOhm bei 100 °C und die Streuinduktivität primärseitig gemessen entsprach ca. 2 µH. Zur Erzielung der kleinen Streuung wurden zwei parallelgeschaltete Primärwicklungen 21, 22 symmetrisch im Wicklungsfenster zur Sekundärwicklung 23 angeordnet, also verschachtelt. Eventuell auftretende Verschiebungsströme zwischen Primär- und Sekundärseite werden von zwischen den Wicklungen liegenden Schirmfolien 24, welche zwischen Isolierfolien 25 liegen, abgeleitet. Diese Ausführung der Transformatorenwicklung ist im Querschnitt in Fig. 9 dargestellt.

Die Pausenzeit zwischen zwei aufeinanderfolgenden Pulsen ist üblicherweise im Bereich von einigen µs, kann aber bis auf minimal 0,5 µs reduziert werden. Diese Zeit sollte jedenfalls abgewartet werden, bevor die Transistoren wieder geöffnet werden, um allfällige Kurzschlüsse zwischen den beiden Schalttransistoren zu vermeiden.

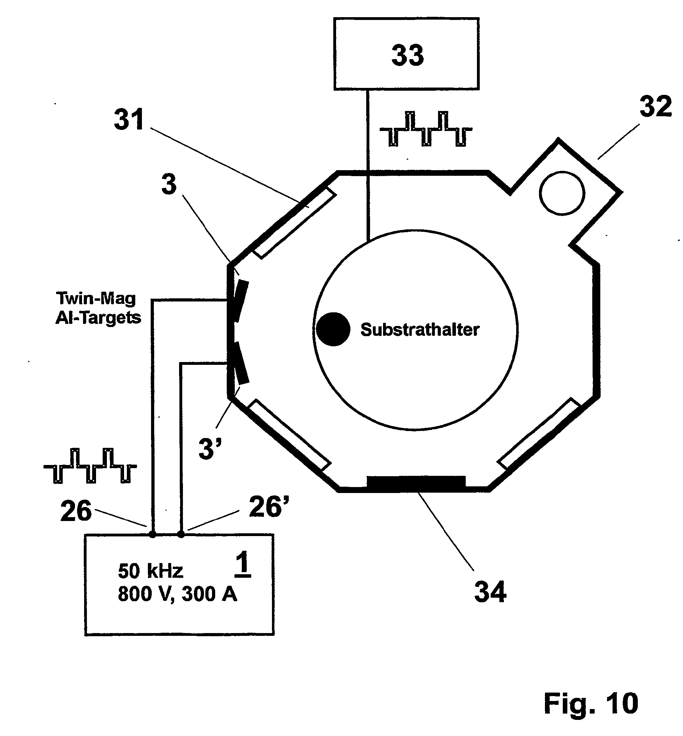

Zum Zünden des Plasmas ist in bekannter Weise eine Spannungsüberhöhung notwendig, die der Generator alleine ohne zusätzliche Massnahmen nicht liefert. Es können entweder zusätzliche Plasmazündeinrrichtungen verwendet werden oder es kann am Ausgang des Generators ein LC-Glied angeordnet werden oder als parasitäre Anordnung ausgebildet sein, wodurch über eine resonante Spannungserhöhung an dem gebildeten Schwingkreis eine Zündspannung beim Anfahren erzielt wird. Nach erfolgter Zündung brennt das Plasma ohne zusätzliche Massnahmen weiter auch während den Pulspausen. Wie bereits erwähnt worden ist, ist der erfindungsgemässe Generator speziell geeignet für die Herstellung von reaktiven Schichten mit Hilfe von Vakuumzerstäubungsprozessen. Insbesondere dort wo schlecht leitende Schichten oder gar dielektrische Schichten reaktiv vom metallischen Target zerstäubt werden sollen, ist es möglich, mit dem vorliegenden Generator Schichten hoher Qualität unter Produktionsbedingungen zu realisieren. Der Generator ist besonders für diejenigen reaktiven Anwendungen geeignet, wo besondere kristalline Schichteigenschaften gefordert sind. Dies trifft insbesondere bei Materialien zu wie SiO₂, ZrO₂ und Al₂O₃. Vorallem bei Al₂O₃, welches in verschiedenen kristallinen Modifikationen vorkommen kann, ermöglicht es der erfindungsgemässe Generator, eine Prozessführung zu realisieren, welche gezielt die bevorzugte kristalline Modifikation ermöglicht. Besonders für die Anwendung von Hartstoffschichten in Verschleissschutzanwendungen, wo spezielle harte Schichten mit Härtegraden grösser 2200 HK notwendig sind, ist der erfindungsgemässe Generator mit Vorteil einzusetzen. Es war mit dem vorliegenden Generator möglich, in einer Vakuumbeschichtungsanlage mit Hilfe der Magnetronzerstäubung gezielt kristallines Aluminiumoxyd abzuscheiden. Als Beschichtungsanlage wurde eine kommerzielle Anlage mit der Bezeichnung BAI 1200 der Firma Balzers in Liechtenstein verwendet (Patent US 5,709,784). In Fig.10 ist schematisch und im Querschnitt die verwendete Anlagenkonfiguration dargestellt. Es wurden zwei rechteckförmige Magnetronkathoden 3, 3' eingesetzt mit Targets aus Aluminium mit hoher Reinheit von 99,9995 % und einer Fläche von jeweils 430 mm². Die beiden Magnetronzerstäubungsquellen 3, 3' wurden eng nebeneinander an einem Flansch angeordnet und mit einem Winkel von jeweils 15 ° zueinander verkippt, wobei beide Kathoden elektrisch isoliert angebracht worden sind und an die beiden Ausgänge 26, 26' des Generators angeschlossen wurden. Somit war jeweils eines der Targets als Kathode geschaltet, während zum gleichen Zeitintervall das andere Target als Anode verschaltet war. Entsprechend der elektrischen Ausführung des Generators waren während der Pulspause die beiden Kathoden gegeneinander elektrisch kurzgeschlossen. Die für das Ausführungsbeispiel realisierten typischen Werte für den Generator wurden zur Übersicht nochmals in Tabelle 1 zusammengefasst. Angegeben sind dort auch im Vergleich die sinnvoll Realisierbaren für diese Prozesstechnik.

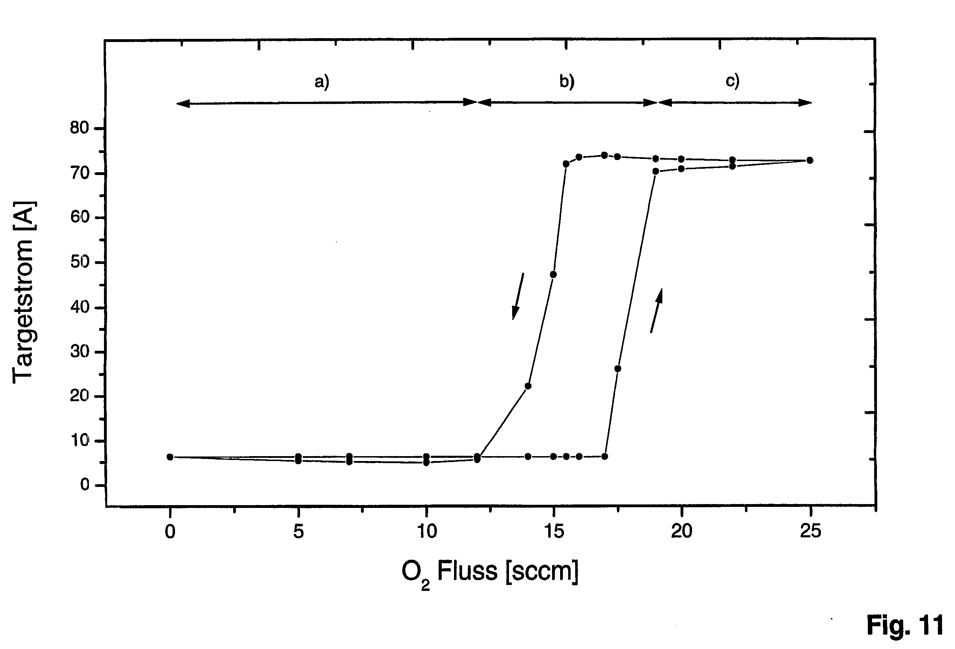

Vor der Deposition der Schichten wurde zunächst eine Kennlinie aufgenommen, die bei konstant gehaltener Targetspannung von 750 Volt und einer Stromwechselfrequenz von 42 kHz, bei einer Puls- und Pausenzeit von jeweils 6 µs, den Targetstrom [A] also den maximal jeweils über einer Kathode fliessenden Strom während eines Pulszeitintervalls als Funktion des Sauerstoffanteils im Argon-Sauerstoff-Gasgemisch darstellt. Diese in Fig. 11 dargestellte Kennlinie zeigt an, ab welchem Sauerstoffanteil O₂ in [sccm] im Gasgemisch das Target sich signifikant mit einer Oxydschicht belegt und grenzt die Bereiche des metallischen Mode a), des Übergangs-Mode b) und des oxydischen Mode c) bei hohen Sauerstoffanteilen voneinander ab. Diese Kennlinie hängt im einzelnen von der elektrischen Ausführung des verwendeten Generators und der Parameterwahl (wie Ausgangsimpedanz, Spannung, Frequenz, der Anlagengeometrie, der Art des Gaseinlasses, dem Magnetfeld hinter den Kathoden, dem Druck etc.) ab. Um stöchiometrische Oxydschichten abzuscheiden, muss die Prozessführung mindestens im Übergangsbereich erfolgen. Das bedeutet, der Sauerstofffluss muss mindestens so hoch sein, dass die Targetoberfläche beginnt, sich mit einer Oxydschicht zu belegen. Hieraus ergibt sich ein erhöhter Targetstrom durch die grössere Anzahl generierter Sekundärelektronen des Oxyds im Vergleich zum rein metallischen Mode. In diesem Fall wurde zur Abscheidung der Oxydschicht der Sauerstofffluss mittels einem PID-Regler auf einen Wert geregelt, damit sich aufgrund des Oxydationsgrades an der Targetoberfläche ein Stromwert von 50 Ampere ergab. Der Total-Druck der Argon-Sauerstoff-Mischung liegt bei solchen reaktiven Magnetronprozessen typischerweise in Bereichen von 10⁻³ bis einigen 10⁻² mbar.

Die Beschichtung der in der Gamma-Phase kristallierten Schichten erfolgte bei Temperaturen um 550 °C, einem Argon-Sauerstoff-Flussverhältnis von etwa 7:1 und Gesamtdrücken um 2,5 * 10⁻³ mbar. Während der Beschichtung standen die Substrate in einem Abstand d von 13 cm zentral vor den beiden Kathoden. Um die benötigten Temperaturen zu erreichen, kann auf bekannte Art eine Substratheizung 31 verwendet werden. Für eine Vorbehandlung der Substrate bzw. der Werkstücke kann an der Anlage eine Ätzeinrichtung 32 eingesetzt werden, um beispielsweise die Schichthaftung zu verbessern. Zusätzlich ist es auch möglich mit einer Beschichtungsquelle, wie mit einer Arc-Verdampfungsquelle 34 und/oder einer Magnetron-Zerstäubungsquelle, eine Haftschicht abzuscheiden. Eine weitere Möglichkeit die Schichtqualität zu beeinflussen bzw. zu kontrollieren, besteht in der Möglichkeit, einen Substratbias 33, vorzugsweise gepulst wie mit 50 kHz und einigen KW Betriebsleistung, zu verwenden.

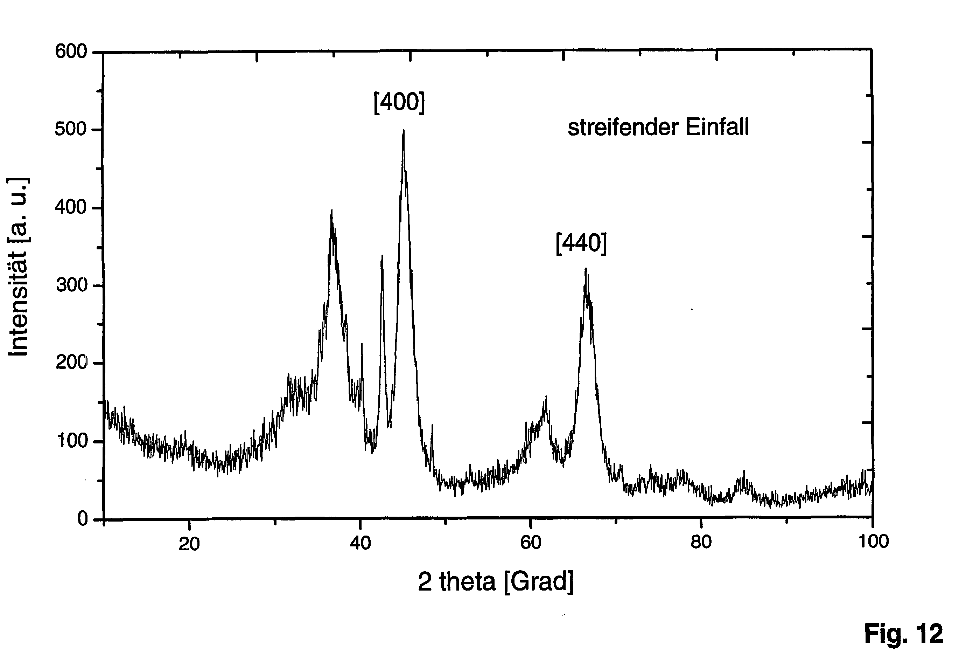

Fig. 12 zeigt das an einer in der Gamma-Phase kristallisierten Schicht aufgenommene Röntgenbeugungspektrum. Man erkennt deutlich die Peaks der an den [400] und [440] Ebenen gebeugten Strahlung bei 45,9 und 67,1 °. Die Härte der Schicht betrug etwa 2400 HK und entsprach damit den für Gamma-Al₂O₃-Schichten veröffentlichten Erwartungen. Tabelle 2 zeigt die jeweils verwendeten Parameter zur Deposition der Schichten. So konnten für Verschleissschutzanwendungen hochwertige sowohl in der Gamma- als auch in der Alpha-Phase kristallierte Al₂O₃ bzw. (AlMe)ₓO_{y}, insbesondere (AlCr)ₓO_{y} und (AlFe)ₓO_{y} abgeschieden werden. In Tabelle 3 sind Gesamt- und Vorzugsbereiche angegeben, in denen die Abscheidungen der Gamma-Phase und Alpha-Phase von Al₂O₃ möglich ist. Da der Prozess im oxydischen Bereich, also bei relativ hohen O₂-Flüssen bzw. Partialdrücken, gefahren werden muss, oxydieren Bereiche ausserhalb des Sputtergrabens am Target, derart dass es hier zu lokalen elektrischen Aufladungen auf der Targetoberfläche kommt. Diese Aufladungen würden eine ordentliche Prozessführung verunmöglichen. Der erfindungsgemässe Generator ist aber in der Lage diese Aufladungen abzubauen und für konstante Prozessbedingungen zu sorgen. Ausserdem ist es möglich, bei starken Entladungen solche auch kurzzeitig auszutasten, ohne den Prozess drastisch zu stören oder den Generator zu zerstören. Es treten hierbei immerhin während der Prozessführung etwa 50 Ampere Maximalstrom auf und im Fall von Extremsituationen bis über 300 Ampere bei Frequenzen von 50 kHz.

**Tabelle 1**

| | *Spannung [V]* | *Stromspitze [A]* | *Puls [us]* | *Pulspause [us]* | *Frequenz [kHz]* |
|---|---|---|---|---|---|
| *realisiert* | *0 bis 800* | *300* | *≥5* | *≥5* | *≤50* |
| *sinnvoll^{*)} realisierbar* | *0 bis 5000* | *600* | *≥2* | *>0* | *≤200* |

| | | | | | |
|---|---|---|---|---|---|
| ^{*)} *nicht alle Grenzwerte gleichzeitig realisierbar* | | | | | |

**Tabelle 2**

| *Al2O3 Kristall* | *P [mbar]* | *V [kHz]* | *T [°C]* | *U [V]* | *I [A]* | *Ar [sccm]* | *O2 [sccm]* | *Bias [V]* |
|---|---|---|---|---|---|---|---|---|
| *Gamma* | *2,5 10⁻³* | *42* | *550* | *750* | *50* | *100* | *14,5* | *50 bp^{*)}* |
| *Alpha* | *4,4 10⁻³* | *25* | *800* | *800* | *30* | *94* | *8* | *float* |

| | | | | | | | | |
|---|---|---|---|---|---|---|---|---|
| ^{*)} *bipolar puls 50 kHz* | | | | | | | | |

**Tabelle 3**

| *Al2O3 Kristall* | *V [kHz]* | *T [°C]* | *U [V]* | *Ar [sccm]* | *O2 [sccm]* | *Bias [V]* |
|---|---|---|---|---|---|---|
| *Gamma* | *10 - 100* | *400 - 600* | *500 - 1000* | *Var. ¹⁾* | *var. ¹⁾* | *0-200²⁾* |
| *Alpha* | *10 - 100* | *600 - 800* | *500 - 1000* | *Var. ¹⁾* | *var. ¹⁾* | *0-200²⁾* |

| | | | | | | |
|---|---|---|---|---|---|---|
| *¹⁾ variabel je nach Hysterese, vorzugsweise im Übergangsbereich bzw. oxidischer Bereich* *²⁾ einstellbar 0 - 200 V, bevorzugt 50 - 150 V zur Anpassung der Mikrostruktur, Dichte und Haftung.* | | | | | | |

Mit dem erfindungsgemässen Generator war es somit möglich, Aluminiumoxyd in der Gamma-Phase in einem Temperaturbereich von 400 bis 600 °C zuverlässig abzuscheiden. Das Gamma-Al₂O₃ ist besonders vorteilhaft in der Hartstoffanwendung einzusetzen, da bei den relativ tiefen Temperaturen, die dann noch unter den Anlasstemperaturen verschiedener Stähle wie z.B. HSS liegen, auch Stahlkörper beschichtet werden können, ohne das Stahlsubstrat negativ zu beeinflussen. Sogar Alpha-Al₂O₃ abzuscheiden, war mit dem vorliegenden Generator möglich, allerdings bei etwas höheren Temperaturen im Bereich von 600 bis 800 °C. Die Möglichkeit nun solche qualitativ hochstehenden und harten Al₂O₃-Schichten abscheiden zu können, dürften im Hartstoffbereich neue Anwendungen erschliessen. Der erfindungsgemässe Generator ist darüberhinaus nicht nur für diesen Bereich erfolgversprechend einsetzbar, sondern vorallem auch in allen Bereichen, wo sensible Reaktivprozesse realisiert werden sollen.

## Patentansprüche

1. Vakuumplasmagenerator mit einem Ausgang (26, 26') zur Speisung einer Plasmaentladung zur Behandlung von Werk-stücken in einer Vakuumkammer wobei dieser umfasst:
- einen Netzanschluss (6a) für den Anschluss an ein Wechselspannungsnetz;
- einen Netzgleichrichter (6) verbunden mit
- einem Konverter (7) mit einem Steuereingang (7a) zur Einstellung und/oder Regelung der Konverterausgangsspannung;
- eine mit dem Konverterausgang (7) verbundene gesteuerte Vollbrückenschaltung (13) mit einem potentialfreien Generatorausgang (26, 26'), welche geeignet ist, die Konverterausgangsspannung in Pulse von 1 bis 500 kHz umzusetzen, wobei in die Brücke (13) ein potential trennender Transformator (14) geschaltet ist zur galvanischen Entkopplung des Generatorausganges (26, 26') und wobei das Spannungsübersetzungsverhältnis des Transforma-tors (14) maximal 1:2 beträgt.

2. Generator nach Anspruch 1 **dadurch gekennzeichnet, dass** das Spannungsübersetzungsverhältnis der Brückenschaltung (13) mit Transformator (14) maximal 1:1,5 beträgt.

3. Generator nach einem der Ansprüche 1 oder 2 **dadurch gekennzeichnet, dass** der Transformator (14) eine Streuinduktivität (16,17) unter 50 µH, bevorzugt unter 10 µH, aufweiset.

4. Generator nach einem der vorhergehenden Ansprüche **dadurch gekennzeichnet, dass** der Konverter (7) ein getakteter Konverter ist, vorzugsweise ein buck-boost-Konverter zur Einstellung einer Ausgangsspannung die sowohl kleiner als auch grösser als die Eingangsspannung ist.

5. Generator nach einem der vorhergehenden Ansprüche **dadurch gekennzeichnet, dass** die Brückenschaltung (13) bipolare Pulse erzeugt.

6. Generator nach einem der vorhergehenden Ansprüche **dadurch gekennzeichnet, dass** die Brückenschaltung (13) Steuermittel aufweist zu wahlweisen Einstellung und/oder Regelung des Pulsverhaltens, wie die Schaltfrequenz, das Tastverhältnis, die Pulsdauer und zur Einstellung der Puls-Kurvenform.

7. Generator nach einem der vorhergehenden Ansprüche **dadurch gekennzeichnet, dass** die Brückenschaltung (13) zwischen aufeinander folgenden Pulsen eine Pulspause ausbildet.

8. Generator nach Anspruch 7 **dadurch gekennzeichnet, dass** die Brückenschaltung (13) in den Pulspausen den Transformator (14) primärseitig kurz schliesst.

9. Generator nach einem der vorhergehenden Ansprüche **dadurch gekennzeichnet, dass** mindestens zwei Brückenschaltungen (13) dem Konverter (7) nachgeschaltet sind.

10. Generator nach Anspruch 9 **dadurch gekennzeichnet, dass** vier Brückenschaltungen dem Konverter (7) nachgeschaltet sind.

11. Generator nach einem der Ansprüche 9 oder 10 **dadurch gekennzeichnet, dass** jeder Brückenschaltung (13) ein Transformator (14) zugeordnet ist und die Sekundärseiten der Transformatoren (14) parallel geschaltet sind.

12. Generator nach einem der Ansprüche 9 bis 11 **dadurch gekennzeichnet, dass** die Brückenschaltungen (13) phasenversetzt geschaltet sind.

13. Verfahren zur Herstellung einer Schicht durch reaktives abscheiden aus einem Plasma, **dadurch gekennzeichnet, dass** das Plasma mit einem Vakuumplasmagenerator nach einem der Ansprüche 1 bis 12 betrieben wird.

14. Verfahren nach Anspruch 13 **dadurch gekennzeichnet, dass** der Generatorausgang (26, 26') mit zwei Abscheideelektroden (3) verbunden ist.

15. Verfahren nach einem der Ansprüche 13 oder 14 **dadurch gekennzeichnet, dass** dielektrische Schichten reaktiv abgeschieden werden.

16. Verfahren nach einem der Ansprüche 13 bis 15 **dadurch gekennzeichnet, dass** die Schicht durch Sputtern, insbesondere Magnetronsputtern abgeschieden wird.

17. Verfahren nach einem der Ansprüche 13 bis 16 **dadurch gekennzeichnet, dass** die Schicht eine Hartstoffschicht ist, insbesondere eine reaktiv abgeschiedene Metalloxyd Schicht MeₓO_{y}.

18. Verfahren nach Anspruch 17 **dadurch gekennzeichnet, dass** die Hartstoffschicht eine Al₂O₃ Schicht ist.

19. Verfahren nach Anspruch 17 oder 18 **dadurch gekennzeichnet, dass** die Hartstoffschicht ein Mischoxyd ist wie (AlMe)ₓO_{y}, vorzugsweise (AlCr)ₓO_{y} und/oder (AlFe)ₓO_{y}.

20. Verfahren nach einem der Ansprüche 13 bis 19 **dadurch gekennzeichnet, dass** die kristalline Struktur der Schicht im wesentlichen eine Alphaphase und/oder eine Gammaphase aufweist wobei die Gammaphase bevorzugt ist.

## Claims

1. Vacuum plasma generator with an output (26, 26') for feeding a plasma discharge for the treatment of workpieces in a vacuum chamber, comprising:
- a mains connection (6a) for the junction to an AC voltage mains;
- a mains rectifier (6) connected to
- a converter (7) with a control input (7a) for the setting and/or regulation of the converter output voltage;
- a controlled full bridge circuit (13) connected to the converter output (7) with a potential-free generator output (26, 26'), which is adapted to transpose the converter output voltage into pulses of 1 to 500 kHz, wherein a potential-isolating transformer (14) is switched into the bridge (13) for the galvanic decoupling of the generator output (26, 26'), and wherein the voltage transformation ratio of the transformer (14) is maximally 1:2.

2. Generator of claim 1, **characterised in that** the voltage transformation ratio of the bridge circuit (13) with transformer (14) is maximally 1:1.5.

3. Generator of claim 1 or 2, **characterised in that** the transformer (14) has a leakage inductance (16, 17) below 50 µH, preferably below 10 µH.

4. Generator of one of the preceding claims, **characterised in that** the converter (7) is a clocked converter, preferably a buck-boost converter for setting an output voltage, which is lower as well as also higher than the input voltage.

5. Generator of one of the preceding claims, **characterised in that** the bridge circuit (13) generates bipolar pulses.

6. Generator of one of the preceding claims, **characterised in that** the bridge circuit (13) comprises control means for the optional setting and/or regulation of the pulse behaviour, such as the switching frequency, the duty factor, the pulse width and for setting the pulse curve form.

7. Generator of one of the preceding claims, **characterised in that** the bridge circuit (13) develops a pulse interspace between successive pulses.

8. Generator of claim 7, **characterised in that** the bridge circuit (13) short circuits the transformer (14) at the primary side during the pulse interspaces.

9. Generator of one of the preceding claims, **characterised in that** at least two bridge circuits (13) are connected succeeding the converter (7).

10. Generator of claim 9, **characterised in that** four bridge circuits are connected succeeding the converter (7).

11. Generator of claim 9 or 10, **characterised in that** a transformer (14) is assigned to each bridge circuit (13) and that the secondary sides of the transformers (14) are connected in parallel.

12. Generator of one of claims 9 to 11, **characterised in that** the bridge circuits (13) are switched offset in phase.

13. Method for manufacturing a layer by reactive deposition out of a plasma, **characterised in that** the plasma is operated with a vacuum plasma current supply of one of claims 1 to 12.

14. Method of claim 13, **characterised in that** the generator output (26, 26') is connected with two deposition electrodes (3).

15. Method of claim 13 or 14, **characterised in that** dielectric layers are deposited reactively.

16. Method of one of claims 13 to 15, **characterised in that** the layer is deposited by sputtering, in particular magnetron sputtering.

17. Method of one of claims 13 to 16, **characterised in that** the layer is a hard material layer, in particular a reactively deposited metal oxide layer MeₓO_{y}.

18. Method of claim 17, **characterised in that** the hard material layer is an Al₂O₃ layer.

19. Method of claim 17 or 18, **characterised in that** the hard material layer is a mixed oxide, such as (AlMe)ₓO_{y}, preferably (AlCr)ₓO_{y} and/or (AlFe)ₓO_{y}.

20. Method of one of claims 13 to 19, **characterised in that** the crystalline structure of the layer comprises substantially an alpha phase and/or a gamma phase, the gamma phase being preferred.

## Revendications

1. Générateur de plasma sous vide comprenant une sortie (26, 26') pour alimenter une décharge de plasma pour traiter des pièces à usiner dans une chambre à vide, ce générateur comprenant :
- un raccordement au réseau (6a) pour un raccordement à un réseau de tension alternative ;
- un redresseur de secteur (6) raccordé à
- un convertisseur (7) avec une entrée de commande (7a) pour régler et/ou réguler la tension de sortie de convertisseur ;
- un circuit en pont intégral (13) commandé et raccordé à la sortie de convertisseur (7) avec une sortie de générateur (26, 26') libre de potentiel lequel sert à transformer la tension de sortie de convertisseur en impulsions comprises entre 1 et 500 kHz, un transformateur sectionneur de potentiel (14) étant monté dans le pont (13) pour le découplage galvanique de la sortie du générateur (26, 26') et le rapport de transformation en tension du transformateur (14) étant au maximum de 1:2.

2. Générateur selon la revendication 1, **caractérisé en ce que** le rapport de transformation en tension du circuit en pont (13) avec transformateur (14) est de maximum 1:1,5.

3. Générateur selon la revendication 1 ou 2, **caractérisé en ce que** le transformateur (14) présente une inductance de fuite (16, 17) inférieure à 50 µH, de préférence inférieure à 10 µH.

4. Générateur selon l'une des revendications précédentes, **caractérisé en ce que** le convertisseur (7) est un convertisseur cadencé, de préférence un convertisseur buck-boost pour régler la tension de sortie qui peut être aussi bien inférieure ou supérieure à la tension d'entrée.

5. Générateur selon l'une des revendications précédentes, **caractérisé en ce que** le circuit en pont (13) produit des impulsions bipolaires.

6. Générateur selon l'une des revendications précédentes, **caractérisé en ce que** le circuit en pont (13) présente des moyens de commande pour au choix régler et/ou réguler le comportement d'impulsions, comme la fréquence de commutation, le taux d'impulsions, la durée d'impulsion ainsi que pour régler la forme d'onde d'impulsion.

7. Générateur selon l'une des revendications précédentes, **caractérisé en ce que** le circuit en pont (13) forme entre les impulsions successives une pause d'impulsions.

8. Générateur selon la revendication 7, **caractérisé en ce que** le circuit en pont (13) au cours des pauses d'impulsions ferme brièvement le transformateur (14) du côté primaire.

9. Générateur selon l'une des revendications précédentes, **caractérisé en ce qu'**il est monté en aval du convertisseur (7) au moins deux circuits en pont (13).

10. Générateur selon la revendication 9, **caractérisé en ce qu'**il est monté en aval du convertisseur (7) quatre circuits en pont.

11. Générateur selon l'une des revendications 9 ou 10, **caractérisé en ce qu'**il est associé à chaque circuit en pont (13) un transformateur (14) et **en ce que** les côtés secondaires des transformateurs (14) sont raccordés en parallèle.

12. Générateur selon l'une des revendications 9 à 11, **caractérisé en ce que** les circuits en pont (13) sont raccordés en décalage de phase.

13. Procédé pour fabriquer une couche par dépôt réactif à partir d'un plasma, **caractérisé en ce que** le plasma est utilisé avec un générateur de plasma sous vide selon l'une des revendications 1 à 12.

14. Procédé selon la revendication 13, **caractérisé en ce que** la sortie de générateur (26, 26') est raccordée à deux électrodes de séparation (3).

15. Procédé selon l'une des revendications 13 ou 14, **caractérisé en ce que** des couches diélectriques sont séparées par réaction.

16. Procédé selon l'une des revendications 13 à 15, **caractérisé en ce que** la couche est séparée par pulvérisation, en particulier par pulvérisation au magnétron.

17. Procédé selon l'une des revendications 13 à 16, **caractérisé en ce que** la couche est une couche de matière dure, en particulier une couche d'oxyde métallique MeₓO_{y} séparée par réaction.

18. Procédé selon la revendication 17, **caractérisé en ce que** la couche de matière dure est une couche Al₂O₃.

19. Procédé selon la revendication 17 ou 18, **caractérisé en ce que** la couche de matière dure est un oxyde mixte, comme (AlMe)ₓO_{y}, de préférence (AlCr)ₓO_{y} et/ou (AlFe)ₓO_{y}.

20. Procédé selon l'une des revendications 13 à 19, **caractérisé en ce que** la structure cristalline de la couche présente essentiellement une phase alpha et/ou une phase gamma, la phase gamma étant préférée.
